# EUROPEAN PATENT SPECIFICATION

(11) **EP 0 256 917 B1**
(45) Date of publication and mention of the grant of the patent: **24.03.1993**
(21) Application number: 87401753.6
(22) Date of filing: 28.07.1987
(51) Int. Cl.: H01L 21/285, H01L 21/90

(54) **Method of producing interconnection layers using CVD of metal**
Verfahren zum Herstellen von Leiterbahnen beim CVD-Metall
Procédé de fabrication des interconnexions par CVD du métal

(30) Priority: 29.07.1986 US 891972
(43) Date of publication of application: 24.02.1988
(73) Proprietor: DIGITAL EQUIPMENT CORPORATION, Maynard, MA 01754 (US)
(72) Inventor: Gutierrez, Jean-Marie, Shrewsbury Massachusetts 01545 (US)
(74) Representative: Mongrédien, André

(56) References cited:
- JAPANESE JOURNAL OF APPLIED PHYSICS, SUPPLEMENTS, exteded abstracts of the 15th conference on solid state devices and materials, Tokyo, 30th August-1st September 1983, pages 225-228, JP; T. MORIYA et al.: "A new encroachment-free tungsten CVD process with superior selectivity"
- SOLID STATE TECHNOLOGY, vol. 28, no. 12, December 1985, pages 51-59, Port Washington, New York, US; E.K. BROADBENT et al.: "Selective tungsten processing by low pressure CVD"
- INTERNATIONAL ELECTRON DEVICES MEETING, Technical Digest, 7th-9th December 1981, pages 54-57, Washington, D.C., US; P.A. GARGINI et al.: "WOS: low resistance self-aligned source, drain and gate transistors"
- JOURNAL OF VACUUM SCIENCE & TECHNOLOGY A, vol. 3, no. 6, November-December 1985, pages 2298-2302, New York, US; J.-O. CARLSSON et al.: "Selective deposition of tungsten-prediction of selectivity"

## Description

### FIELD OF THE INVENTION

The invention relates to methods of fabricating semiconductor integrated circuit chips, and more particularly to methods of forming interconnection layers on integrated circuit chips where the upper surface of each layer is relatively planar.

### BACKGROUND OF THE INVENTION

Providing several interconnection levels is highly desirable in very large scale integrated circuit (VLSI) technology, as it allows both higher packing density of the active components and greater freedom in their placement on the chip. An interconnection layer typically includes an insulating layer on which a conductive interconnection pattern is formed or in which it is embedded. An interconnection layer is typically formed of two conductor-insulator layers, including an upper layer providing horizontal paths among areas of the chip and a lower conductor-insulator layer providing vertical connections between the conductors in the upper layer and the interconnection layer or the semiconductor therebeneath. The connection in the lower conductor-insulator layers of each interconnetion layer are called solid vias which are through the insulating layer and filled with conductive material provide connections to the underlying interconnection layers or semiconductor devices.

Care must be taken in fabricating the chip to ensure that each interconnection layer is provided with a relatively planar upper surface before the next interconnection layer is applied. Unless this is done, sharp corners and discontinuities, known as steps, can develop in the surface of an interconnection layer. If metal is being used as the conductive material, which is preferred to polysilicon because of its lower resistivity, problems can develop in the interconnections because metals typically have poor coverage over corners and steps. Accordingly, as each interconnection layer is applied, it is desirable to ensure that the top surface of each interconnection layer has a relatively planar upper surface before beginning the next layer.

One approach to achieving a planar upper surface has been the use of a reflowed glass technique. In this technique an interconect layer is covered by a glass, which is then heated close to its melting point so that it "reflows", leaving a planar upper surface. The glass, usually silicon dioxide, has a quite high melting point. The melting point of the silicon dioxide can be reduced by the introduction of phosphorus into the silicon dioxide, which reduces the glass's melting point to about 1000 degrees Celcius. The melting point of the glass can be reduced by about another 100 degrees by the addition of boron to the glass. The drawbacks of the reflowed glass technique stem from the high temperatures required to melt the glass, which temperatures may be higher than the melting points of the metals used as conductors. For example, the reflowed glass technique cannot be used to smooth a surface above an interconnection layer in which aluminum is the conductor, because of aluminum's relatively low melting point. There is also a risk of metal corrosion with the formation of phosphoric acid over time. In addition, boron can diffuse out of the silicon dioxide and into the underlying silicon, which can result in instability in the threshold voltage of MOS transistors.

Refractory metals can be used in place of aluminum as the interconnect material in the reflowed glass process.

The use of refractory metals is disclosed in the following documents :
- Japanese Journal of Applied Physics, Supplements, extended abstacts of the 15th conference on solid state devices and materials, Tokyo, 30th august - 1st September 1983, pages 225-228 JP ; T. MORIYA et al. : "A new encroachment-free tungsten CVD process with superior selectivity" ;
- Solid State Technology, Volume 28, No 12, December 1985, pages 51-59, Port Washington, New York, US ; E.K. Broadbent et al. : "Selective tungsten processing by low pressure CVD".

In these publications a two-step process is described. At first W is deposited on silicon of the substrate and/or polysilicon lines according to the formula

2WF₆ + 3Si → 2W + 3SiF₄

In the second step further deposition of W is accomplished according to the reaction

WF₆ + 3H₂ → W + 6HF

The high melting points of refractory metals ensure that they will not melt during the reflow process. A problem with using such metals, however, is that at temperatures over about 700 degrees Celsius, metal silicide may form where the metal comes in contact with the silicon substrate to form connections, which can increase the resistance of the connection.

Another approach to achieving a planar interconnection layer is the use of lift-off techniques. A layer of resist is used as a mask in the etching of recesses in the surface of the chip. A layer of metal is then formed having thickness comparable to the depth of the recesses, thereby filling the recesses with metal. The metal outside of the recesses is removed by dissolving underlying the layer of resist, which causes the metal on top of the resist to lift off, leaving the metal in the recesses.

A disadvantage of the use of lift-off is the requirement that metal be deposited at low temperatures (about 150 degress Celsius) in order to avoid decomposition of the layer of resist on which the metal is deposited. Metal deposited at such low temperatures is subject to recrystallization and hillock formation during further processing steps of the integrated circuit chip.

### SUMMARY OF THE INVENTION

The present invention aims to provide a method of forming conductor-insulator layers which are suitable for the formation of multiple interconnection layers without the need for processing at the high temperature required in the methods disclosed in the cited documents, wherein refractory metals are used.

A conductor-insulator layer for providing electrical interconnection among devices in an integrated circuit is created by forming a pattern of conductive material in an insulating layer, such that the top surface of the conductive material is substantially even with the top surface of the insulating material. The pattern of conductive material is formed by a process that selectively deposits connductive material in regions where a seed material is present.

In performing the inventive process, a layer of seed material is deposited on the surface of an integrated circuit chip and etched in the pattern desired for the conductive material.

The invention is mainly directed to a method of forming a conductor-insulated layer on an integrated circuit chip, said method comprising the steps of :
A) forming an insulating layer over a surface on the chip,
B) patterning the insulating layer to form at least one recess therethrough,
C) exposing the chip to a first chemical agent which acts to selectively deposit a conducting material on said surface within said recess,
   and characterized in that
D) said method further comprises the steps of i) prior to step (A), forming in the pattern desired for said conductive material a layer of seed material on said surface, said recess being smaller than the patterned layer of seed material, said seed material being used only for the deposition of said conductive material whereby at least part of said seed material is consumed during step (C), and ii) after step, exposing the chip to a second chemical agent which selectively deposits further conductive material on the conductive material in said recess.

### BRIEF DESCRIPTION OF THE DRAWING

The invention is pointed out with particularity in the appended claims. The above and other advantages of the invention may be better understood by referring to the following detailed description in conjunction with the drawing in which :
Figs. 1-6 schematically depict a cross-sectional view of a portion of an integrated circuit chip in successive stages in forming a conductor-insulator layer according to the instant invention;
Fig. 7 depicts, in-cross section, a portion of an integrated circuit chip which has been processed by conventional NMOS techniques to the point at which recesses for metal contact vias have been formed;
Fig. 8 depicts, in-cross section, a portion of an integrated circuit chip with an active device to which electrical connections are formed via four conductor-insulator layers.

### DESCRIPTION OF AN ILLUSTRATIVE EMBODIMENT

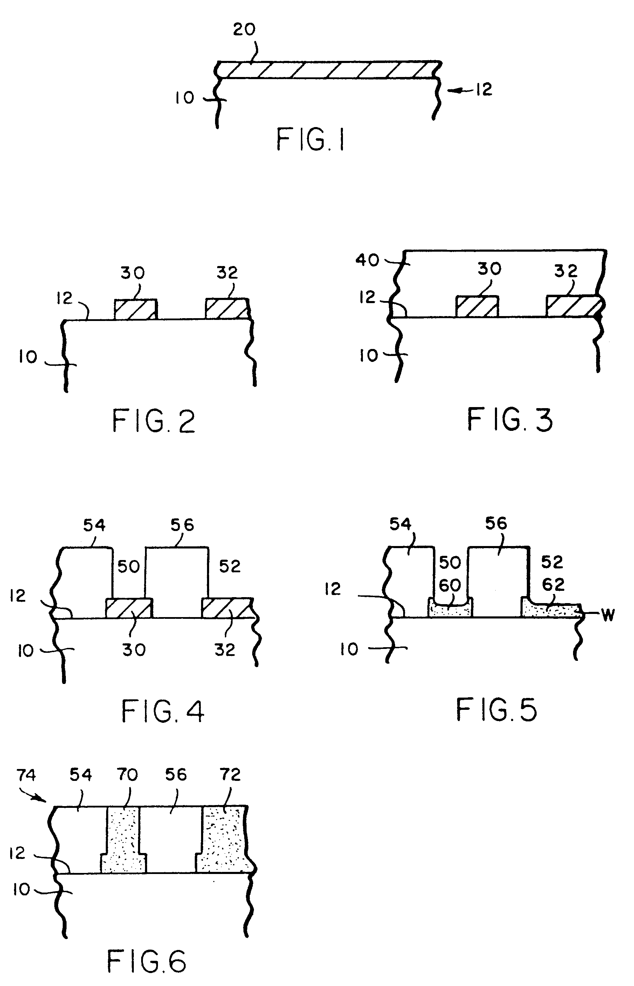

With reference to Fig. 1, an integrated circuit chip 10 has an upper surface 12. Seed material, such as polysilicon, is formed and patterned as illustrated in Figs. 1 and 2. As shown in Fig. 1 a layer 20 of seed material is deposited over the entire surface 12. The seed layer 20 is then patterned by conventional photolithographic techniques, for example, to leave portions 30 and 32. The pattern of the seed material remaining, that is, the pattern defined by portions 30 and 32, corresponds to the desired pattern of conductive material to be deposited in the conductor-insulator layer.

As shown in Fig. 3, a layer of insulating material 40, in this case silicon dioxide, is formed over the seed material portions 30 and 32 and the exposed portions of the surface 12. The thickness of the insulating layer 40 corresponds to the thickness of the conductor-insulator layer being formed. The insulating layer 40 is also patterned, leaving portions of insulating material, represented by portions 54 and 56 as shown in Fig. 4. The patterning leaves recesses 50 and 52 in the insulating layer to expose the seed material portions 30 and 32.

In patterning the silicon dioxide layer, it may be preferable to use a mask which leaves recesses 50 and 52 in the silicon dioxide layer which are slightly narrower than the portions of seed material which are to be exposed. Thus, if there is any misalignment of the masks, the resulting recesses 50 and 52 will not expose the underlying chip 10.

At this point the insulating portion of the conductor-insulator layer has been formed, comprising portions 54 and 56 (Fig. 4). In the next steps, the conductive portion of the conductor-insulator layer is deposited in recesses 50 and 52. The conductive material in one embodiment is selected to be tungsten.

The first step in selectively filling the recesses 50 and 52 with conductive material is to deposit an initial layer of conductive material by a process which deposits conductive material selectively where seed material is exposed. In one embodiment, in which tungsten is to be the conductive material, the chip is immersed in an atmosphere of tungsten fluoride gas. The gas reacts with the silicon seed material according to the following formula:

2 WF₆ + 3 Si ---- 2 W + 3 SiF₄

The solid tungsten is deposited and the silicon fluoride gas is dispersed. The silicon dioxide insulation portions 54 and 56 do not react with the tungsten fluoride gas, and so no tungsten is deposited thereon.

The reaction of tungsten fluoride with silicon will slow and eventually stop after the deposited conductive material (tungsten) is thick enough to prevent contact between the tungsten fluoride and the silicon. The volume of silicon consumed by this reaction is greater than the volume of tungsten deposited. For these two reasons, this reaction probably will not deposit, by itself, sufficient tungsten to fill the recesses 50 and 52.

The result of selective deposition of conductive material on the seed material is illustrated in Fig. 5. In the bottom of each of the recesses 50 and 52 is a layer of tungsten 60 and 62, respectively. The reaction of the tungsten fluoride gas with the exposed silicon seed material consumes all or at least some of the seed material 30 and 32. In Fig. 5, the reaction has consumed all of the seed material.

The next step in the process fills the remaining portions of the recesses 50 and 52 with conductive material. In this embodiment, this is accomplished by introducing hydrogen gas into the atmosphere of tungsten fluoride gas. The hydrogen and tungsten fluoride react according to the following formula:

WF₆ + 3 H₂ ---- W + 6 HF

This reaction occurs in the presence of solid tungsten as a catalyst; thus the reaction results in the selective deposition of tungsten in locations where tungsten was previously deposited by the selective deposition on the seed material.

Unlike the selective deposition on the seed material, this second deposition process does not slow as the thickness of the deposited tungsten increases; the tungsten continues to deposit selectively on the already deposited tungsten at a substantially constant rate. When the reaction has progressed until the recesses 50 and 52 are filled with conductive material 70 and 72 (Fig. 6), the chip 10 may be removed from the tungsten fluoride and hydrogen atmosphere to stop the reaction.

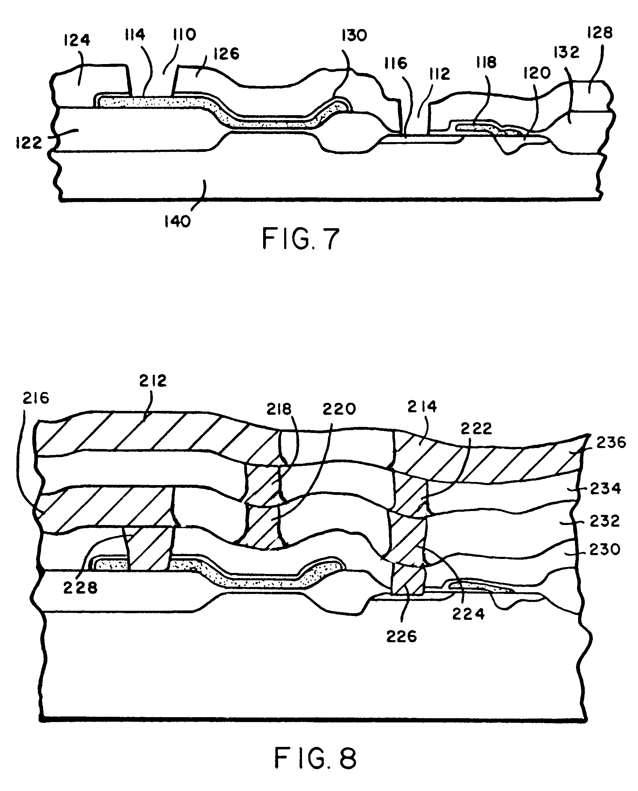

Fig. 6 shows the resulting conductor-insulator layer comprising patterned insulating material 54 and 56 and conductive material 70 and 72. The top surface 74 of the conductor-insulator layer is relatively planar and free of discontinuities. Another conductor-insulator layer can be formed on top of this layer by repeating the above-described steps, as will be shown in connection with Fig. 8.

The above-described process of forming conductor-insulator layers can be integrated into a conventional integrated circuit fabrication process. Fig. 7 shows an integrated circuit chip which has been processed by conventional NMOS processing techniques to the point at which recesses 110 and 112 have been formed, which will be filled with conductive material to form solid contact vias.

Silicon dioxide layers 122, 124, 126, 128, 130, and 132 and polysilicon conductors 114 and 118 have been formed. A silicon substrate 140 has been doped to form a source region 116 and a drain region 120 of an MOS transistor. The layer of polysilicon 118 connects the gate and the drain of the transistor.

At the bottom of each of the recesses 110 and 112 is silicon. Specifically, a portion of the polysilicon conductor 114 forms the bottom of recess 110 and a portion of the silicon of the substrate 140 (doped to form a source region 116) forms the bottom of recess 112. At this stage tungsten can be selectively deposited on the silicon 114 and 116 which is exposed at the bottom of the recesses 110 and 112. The recesses 110 and 112 are filled with conductive material by a process generally as described above in connection with figures 4-6 or known in the art, resulting in a conductor-insulator layer free of discontinuities.

Fig. 8 depicts four conductor-insulator layers 230, 232, 234, and 236. All of the contact vias 218, 222 and 224 and metal interconnection lines 212, 214, 216, and 220 are formed by the process described above in connection with Figs. 4-6. It will be appreciated that interconnection line 220 connects to circuitry out of the plane of Fig. 8. Via 226 is formed directly onto the silicon substrate using the substrate as the seed.

As can be seen in Figs. 7 and 8, the top surface of the integrated circuit chip, at the time the first conductor-insulator layer is to be formed, although uneven, is sufficiently planar to permit the formation of a conductor-insulator layer. The present invention enables the formation of multiple conductor-insulator layers above this surface without exacerbating the unevenness. The top surface of each of the four conductor-insulator layers 230, 232, 234, and 236 shown in Fig. 8 is relatively planar, that is, each conductor-insulator layer is of substantially uniform thickness; thus each succeeding conductor-insulator layer does not exacerbate the unevenness present when the first conductor-insulator layer is formed.

The instant invention can be used to advantage whether or not the process is used to form a planar layer. The instant process does not require metal sputtering or metal etching and thus does not require the expensive equipment needed for these types of chip processing. The only etching that the process requires is the etching of silicon and of silicon dioxide, both of which are well understood and easily controlled. Since with the present invention interconnection layers can be formed of material deposited by chemical vapor deposition, when used over an uneven surface, better step coverage can be obtained using the present invention than is typically obtained when depositing interconnection layers by supttering. Further, refractory metals such as tungsten can be used to form interconnections, and can be deposited at low temperature (although the deposition need not occur at the very low temperature required when using lift-off techniques). In addition to its relatively high melting point, tungsten has better immunity from electromigration than does aluminum, the metal most commonly used for interconnections. Tungsten does not dissolve into silicon, and thus can be used with very shallow junctions without the need for a barrier layer or junction plug.

## Claims

1. A method of forming a conductor-insulated layer on an integrated circuit chip (10), said method comprising the steps of:
A) forming an insulating layer (40, 232, 234, 236) over a surface (12) on the chip (10),
B) patterning the insulating layer (40, 232, 234, 236) to form at least one recess (50, 52) therethrough,
C) exposing the chip to a first chemical agent which acts to selectively deposit a conducting material (60, 62) on said surface (12) within said recess,
D) exposing the chip to a second chemical agent which selectively deposits further conductive material (70, 72) on the conductive material (60 and 62) in said recess,
and characterized in that
said method further comprises the step of prior to step (A), forming a layer of seed material (20) on said surface (12) in the pattern desired for said conductive material, said recess being smaller than the patterned layer of seed material, said seed material being used only for the deposition of said conductive material and said seed material being at least partly consumed in step (C).

2. A method according to claim 1, wherein said deposition of conductive material consumes substantially all said seed material.

3. A method according to claim 1 or 2, wherein said surface (12) comprises a surface of an insulating layer (230, 232, 234, 236).

4. A method according to claim 1 or 2, wherein said chip comprises a substrate and said surface (12) comprises a surface of said substrate.

5. A method according to claim 1 or 2, wherein said chip comprises a polysilicon conductor, and said surface (12) comprises a surface of said conductor.

6. A method according to claim 1 or 2, wherein said insulating layer (40, 232, 234, 236) comprises silicon dioxide and the seed material (20) comprises a polycrystalline silicon material.

7. A method according to claims 1 or 2, wherein said seed material (20) is polycrystalline silicon, and said first chemical agent is tungsten fluoride whereby tungsten replaces said polycrystalline silicon.

8. A method according with claim 7, wherein said second chemical agent is tungsten hexafluoride and hydrogen, whereby additional tungsten (70 and 72) is deposited on the tungsten (60 and 62) which replaced the polycrystalline silicon (30 and 32).

9. A method according claim 1 or 2, wherein said surface (12) comprises a surface of a silicon dioxide layer (122) on said chip.

10. A method according to claim 1 or 2, wherein said first chemical agent comprises tungsten fluoride, and said second-agent-exposing step comprises the step of exposing the chip to a hydrogen gas in the presence of said first chemical agent.

11. A method according to claim 1 or 2, wherein said deposited conductive material forms a contact via.

## Patentansprüche

1. Verfahren zum Ausbilden einer leiterisolierten Schicht auf einem integrierten Schaltungschip (10), wobei das Verfahren die Schritte aufweist:
A) Ausbilden einer Isolationsschicht (40, 232, 234, 236) über einer Oberfläche (12) auf dem Chip (10),
B) Strukturieren der Isolationsschicht (40, 232, 234, 236), um durch sie hindurch zumindest eine Vertiefung (50, 52) auszubilden,
C) Aussetzen des Chips einem ersten chemischen Mittel, das bewirkt, daß selektiv ein leitendes Material (60, 62) auf der Oberfläche (12) innerhalb der Vertiefung abgeschieden wird,
D) Aussetzen des Chips einem zweiten chemischen Mittel, das selektiv weiteres leitendes Material (70, 72) auf dem leitenden Material (60, 62) in der Vertiefung abscheidet,
und dadurch gekennzeichnet, daß das Verfahren weiterhin vor dem Schritt (A) den Schritt des Ausbildens einer Schicht aus Impfmaterial (20) auf der Oberfläche (12) in der Struktur, die für das leitende Material gewünscht wird, aufweist, wobei die Vertiefung schmaler als die strukturierte Schicht aus Impfmaterial ist, das Impfmatieral nur für die Abscheidung des leitenden Materials verwendet wird und wobei das Impfmaterial zumindest teilweise beim Schritt (C) verbraucht wird.

2. Verfahren nach Anspruch 1, worin das Abscheiden des leitenden Materials im wesentlichen das gesamte Impfmaterial verbraucht.

3. Verfahren nach Anspruch 1 oder 2, worin die Oberfläche (12) eine Oberfläche einer Isolationsschicht (230, 232, 234, 236) aufweist.

4. Verfahren nach Anspruch 1 oder Anspruch 2, worin der Chip ein Substrat aufweist und worin die Oberfläche (12) eine Oberfläche des Substrats aufweist.

5. Verfahren nach Anspruch 1 oder Anspruch 2, worin der Chip einen Polysiliziumleiter aufweist und worin die Oberfläche (12) eine Oberfläche des Leiters aufweist.

6. Verfahren nach Anspruch 1 oder Anspruch 2, worin die Isolationsschicht (40, 232, 234, 236) Siliziumdioxyd aufweist und das Impfmaterial (20) ein polykristallines Siliziummaterial aufweist.

7. Verfahren nach Anspruch 1 oder Anspruch 2, worin das Impfmaterial (20) polykristallines Silizium ist und worin das erste chemische Mittel Wolframfluorid ist, wobei das Wolfram das polykristalline Silizium ersetzt.

8. Verfahren nach Anspruch 7, worin das zweite chemische Mittel Wolframhexafluorid und Wasserstoff ist, wobei zusätzliches Wolfram (70, 72) auf dem Wolfram (60, 62) abgeschieden wird, das das polykristalline Silizium (30, 32) ersetzt.

9. Verfahren nach Anspruch 1 oder Anspruch 2, worin die Oberfläche (12) eine Oberfläche einer Siliziumdioxydschicht (122) auf dem Chip aufweist.

10. Verfahren nach Anspruch 1 oder Anspruch 2, worin das erste chemische Mittel Wolframfluorid aufweist und worin der Aussetzungsschritt mit dem zweiten Mittel den Schritt des Aussetzens des Chips einem Wasserstoffgas unter Anwesenheit des ersten chemischen Mittels umfaßt.

11. Verfahren nach Anspruch 1 oder Anspruch 2, worin das abgeschiedene leitende Material eine Durchkontaktierung bildet.

## Revendications

1. Procédé de formation d'une couche à conducteurs isolés sur une pastille à circuit intégré (10), ledit procédé comprenant les étapes de :
A) formation d'une couche isolante (40, 232, 234, 236) sur une surface (12) de la pastille (10),
B) impression de la couche isolante (40, 232, 234, 236) pour former au moins un creux (50, 52) à travers elle,
C) exposition de la pastille à un premier agent chimique qui agit pour déposer sélectivement un matériau conducteur (60, 62) sur ladite surface (12) à l'intérieur dudit creux,
D) exposition de la pastille à un deuxième agent chimique qui dépose sélectivement davantage de matériau conducteur (70, 72) sur le matériau conducteur (60, 62) dans ledit creux,
et caractérisé en ce que ledit procédé comprend de plus l'étape, préalablement à l'étape (A), de formation d'une couche de matériau de germination (20) sur ladite surface (12) selon l'impression désirée pour ledit matériau conducteur, ledit creux étant inférieur à la couche impressionnée de matériau de germination, ledit matériau de germination étant utilisé seulement pour la déposition dudit matériau conducteur et ledit matériau de germination étant au moins partiellement consommé dans l'étape (C).

2. Procédé selon la revendication 1, dans lequel ladite déposition de matériau conducteur consomme sensiblement tout ledit matériau de germination.

3. Procédé selon la revendication 1 ou 2, dans lequel ladite surface (12) renferme une surface d'une couche isolante (230, 232, 234, 236).

4. Procédé selon la revendication 1 ou 2, dans lequel ladite pastille renferme un substrat et ladite surface (12) renferme une surface dudit substrat.

5. Procédé selon la revendication 1 ou 2, dans lequel ladite pastille renferme un conducteur de polysilicium, et ladite surface (12) renferme une surface dudit conducteur.

6. Procédé selon la revendication 1 ou 2, dans lequel ladite couche isolante (40, 232, 234, 236) renferme du dioxyde de silicium et le matériau de germination (20) renferme un matériau de silicium polycristallin.

7. Procédé selon la revendication 1 ou 2, dans lequel ledit matériau de germination (20) est en silicium polycristallin, et ledit premier agent chimique est du fluorure de tungstène, moyen par lequel du tungstène remplace ledit silicium polycristallin.

8. Procédé selon la revendication 7, dans lequel ledit deuxième agent chimique est de l'hexafluorure de tungstène et de l'hydrogène, moyen par lequel du tungstène additionnel (70 et 72) est déposé sur le tungstène (60 et 62) qui a remplacé le silicium polycristallin (30 et 32).

9. Procédé selon la revendication 1 ou 2, dans lequel ladite surface (12) renferme une surface d'une couche de dioxyde de silicium (122) sur ladite pastille.

10. Procédé selon la revendication 1 ou 2, dans lequel ledit premier agent chimique renferme du fluorure de tungstène, et ladite étape d'exposition au deuxième agent chimique renferme l'étape d'exposition de la pastille à un gaz d'hydrogène en présence dudit premier agent chimique.

11. Procédé selon la revendication 1 ou 2, dans lequel ledit matériau conducteur déposé forme un trou de contact.
